(19) Europäisches Patentamt
European Patent Office
Office européen des brevets

(11) EP 4 611 323 A1

(12) **EUROPEAN PATENT APPLICATION**
published in accordance with Art. 153(4) EPC

(43) Date of publication:
**03.09.2025 Bulletin 2025/36**

(21) Application number: **22964751.6**

(22) Date of filing: **09.11.2022**

(51) International Patent Classification (IPC):
***H04L 27/00*** *(2006.01)*

(52) Cooperative Patent Classification (CPC):
**H04L 27/00**

(86) International application number:
**PCT/CN2022/130828**

(87) International publication number:
**WO 2024/098276 (16.05.2024 Gazette 2024/20)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Huawei Technologies Co., Ltd.**
**Shenzhen, Guangdong 518129 (CN)**

(72) Inventors:
- **TONG, Jiajie**
  **Shenzhen, Guangdong 518129 (CN)**
- **ZHANG, Huazi**
  **Shenzhen, Guangdong 518129 (CN)**
- **WANG, Xianbin**
  **Shenzhen, Guangdong 518129 (CN)**
- **WANG, Jun**
  **Shenzhen, Guangdong 518129 (CN)**

(74) Representative: **Körber, Martin Hans**
**Mitscherlich PartmbB**
**Patent- und Rechtsanwälte**
**Karlstraße 7**
**80333 München (DE)**

# (54) COMMUNICATION METHOD, COMMUNICATION APPARATUS, AND COMMUNICATION SYSTEM

(57) Embodiments of this application provide a communication method, a communication apparatus, and a communication system. The method includes: respectively encoding m first codewords to obtain m second codewords, where the second codeword is obtained by repeating the first codeword, and m is a positive integer; separately coupling additional information with the m second codewords to obtain m coupled codes; and sending the m coupled codes. **In** this solution, the additional information is coupled with the m second codewords to obtain the m coupled codes, and the m coupled codes are transmitted. After the additional information in the m coupled codes is decoupled, transmission effect that is the same as or similar to that of merely transmitting the m second codewords may be obtained. In this way, more information can be sent additionally without changing a decoding rate of the second codeword, and channel throughput performance is improved.

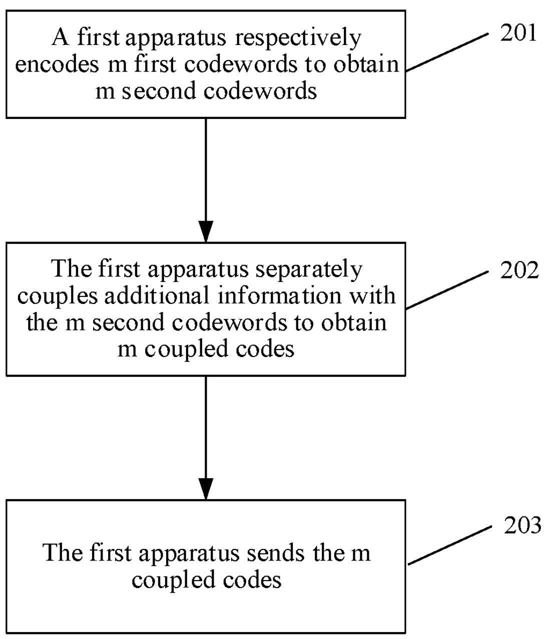


FIG. 2

EP 4 611 323 A1

## Description

### TECHNICAL FIELD

Embodiments of this application relate to the field of wireless communication technologies, and in particular, to a communication method, a communication apparatus, and a communication system.

### BACKGROUND

A polar code is a channel coding scheme that can be strictly proved to reach a Shannon channel capacity, and has features such as good performance and low complexity. A mother code length of the polar code is an integer power of 2. For example, the mother code length is 256 bits, 512 bits, or the like.

When a code length required for actual communication is different from the mother code length, matching between the code length and the mother code length needs to be implemented in a manner such as puncturing or retransmission. Puncturing or retransmission means that several positions in a mother code obtained through encoding are removed or retransmitted, so that the mother code meets a code length requirement. For example, in 5th generation (5th generation, 5G) communication, a maximum mother code length of a downlink polar code is 512 bits, and a maximum code length of a downlink sent codeword may reach 1728 bits. Therefore, the mother code whose length is 512 bits may be repeatedly sent, so that a code length of an actually sent codeword reaches 1728 bits. Each coded bit in the mother code is repeatedly sent three or four times.

In this solution, because the coded bit needs to be repeatedly sent, channel utilization decreases. Therefore, how to further improve channel throughput performance while ensuring effect of repeatedly sending the coded bit needs to be resolved.

### SUMMARY

Embodiments of this application provide a communication method, a communication apparatus, and a communication system, to improve channel performance.

According to a first aspect, an embodiment of this application provides a communication method. The method may be performed by a first apparatus. The method includes: respectively encoding m first codewords to obtain m second codewords, where the second codeword is obtained by repeating the first codeword, and m is a positive integer; separately coupling additional information with the m second codewords to obtain m coupled codes, where the coupled code includes a first part and a second part, the first part is the same as a first codeword that is in the m first codewords and that corresponds to the coupled code, and the second part is obtained by coupling the additional information with a second codeword that is in the m second codewords and that corresponds to the coupled code; and sending the m coupled codes.

In the foregoing solution, the additional information is coupled with the m second codewords to obtain the m coupled codes, and the m coupled codes are transmitted. After the additional information in the m coupled codes is decoupled, transmission effect that is the same as or similar to that of merely transmitting the m second codewords may be obtained. In this way, more information can be sent additionally without changing a decoding rate of the second codeword, and channel throughput performance is improved.

In a possible implementation method, each element value of the second part is obtained by performing an exclusive OR operation on each element value in the additional information and each element value in the second codeword except the first codeword.

In the foregoing solution, the additional information may be coupled to each second codeword to obtain a corresponding coupled code, thereby improving channel throughput performance.

In a possible implementation method, an (i+1)$^{th}$ first codeword in the m first codewords is $X^i$ and $X^i=\{x_0^i, x_1^i, x_2^i, \dots, x_{N^i-1}^i\}$, an (i+1)$^{th}$ coupled code in the m coupled codes is $E^i$ and $E^i=\{e_0^i, e_1^i, e_2^i, \dots, e_{M^i-1}^i\}$, the additional information is Y and Y=$\{y_0, y_1, y_2, \dots, Y_{N'-1}\}$, i=0, 1, 2, ..., m-1, $N^i$ represents a quantity of element values of $X^i$, $M^i$ represents a quantity of element values of $E^i$, and N' represents a quantity of element values of Y;

a first part of $E^i$ is $\{e_0^i, e_1^i, e_2^i, \dots e_{N^i-1}^i\}$, and the first part is generated by using the following method:

$$\text{for}(j=0;\ j<N^i;\ j=j+1)$$

$$e_j^i = x_j^i;$$

and

a second part of $E^i$ is $\{e^i_{N^i}, e^i_{N^i+1}, e^i_{N^i+2}, \dots e^i_{M^i-1}\}$, and the second part is generated by using the following method:

$$\text{for}(j=N^i;\ j<M^i;\ j=j+1)$$

$$e_j^i = x^i_{mod(j,N^i)}{}^\wedge y_{mod(j-N^i+\Delta^i,N')},$$

where

mod represents a modulo operation, ^ represents an exclusive OR operation, and $\Delta^i$ represents a coupling sequence number offset value of the additional information.

In a possible implementation method, $\Delta^i = i * mod\left(\sum_{i=0}^{m-1}(M^i - N^i), N'\right)$, where $\Sigma$ represents a summation operation. In the foregoing solution, a manner of coupling the additional information with the second codeword may be flexibly set, and specifically, a mapping relationship between the element value of the additional information and the element value of the second codeword for performing an exclusive OR operation may be flexibly selected.

In a possible implementation method, additional information coupled in the m coupled codes is the same.

In the foregoing solution, the same additional information is coupled to the m second codewords to obtain the m coupled codes, so that enhanced sending of the additional information can be implemented, and a receive end can accurately decode the additional information.

In a possible implementation method, the first codeword is a polar code.

According to a second aspect, an embodiment of this application provides a communication method. The method may be performed by a first apparatus. The method includes: receiving m groups of log-likelihood ratios, where the m groups of log-likelihood ratios one-to-one correspond to m coupled codes, the m coupled codes one-to-one correspond to m second codewords, the m second codewords are obtained by repeatedly encoding m first codewords, and m is a positive integer respectively; and decoding the m groups of log-likelihood ratios to obtain a decoding result of additional information and a decoding result of the m first codewords, where the coupled code includes a first part and a second part, the first part is the same as a first codeword that is in the m first codewords and that corresponds to the coupled code, and the second part is obtained by coupling the additional information with a second codeword that is in the m second codewords and that corresponds to the coupled code.

In the foregoing solution, the additional information is coupled with the m second codewords to obtain the m coupled codes, and the m coupled codes are transmitted. After the additional information in the m coupled codes is decoupled, transmission effect that is the same as or similar to that of merely transmitting the m second codewords may be obtained. In this way, more information can be sent additionally without changing a decoding rate of the second codeword, and channel throughput performance is improved.

In a possible implementation method, the decoding the m groups of log-likelihood ratios to obtain a decoding result of additional information and a decoding result of the m first codewords includes: for one group of log-likelihood ratios in the m groups of log-likelihood ratios, decoupling a second part of the group of log-likelihood ratios based on a first part of the group of log-likelihood ratios, to obtain a log-likelihood ratio of the additional information, where a quantity of element values in the first part of the group of log-likelihood ratios is equal to a quantity of element values in a first part of a coupled code that is in the m coupled codes and that corresponds to the group of log-likelihood ratios, and a quantity of element values in the second part of the group of log-likelihood ratios is equal to a quantity of element values in a second part of the coupled code that is in the m coupled codes and that corresponds to the group of log-likelihood ratios; determining the decoding result of the additional information based on log-likelihood ratios that are of the additional information and that respectively correspond to the m groups of log-likelihood ratios; and decoupling the group of log-likelihood ratios based on the decoding result of the additional information, to obtain a decoding result of a first codeword corresponding to the group of log-likelihood ratios.

In the foregoing solution, the decoding result of the additional information is first obtained through decoding, and then each group of log-likelihood ratios is decoupled based on the additional information, to obtain a decoding result of a corresponding first codeword, so that fast and accurate decoding can be implemented.

In a possible implementation method, the determining the decoding result of the additional information based on log-likelihood ratios that are of the additional information and that respectively correspond to the m groups of log-likelihood

ratios includes: determining a sum value of the log-likelihood ratios that are of the additional information and that respectively correspond to the m groups of log-likelihood ratios; and decoding the sum value to obtain the decoding result of the additional information.

In the foregoing solution, m log-likelihood ratios of the additional information are first obtained through decoding, and then the m log-likelihood ratios are summed up and decoded to obtain the decoding result of the additional information. This helps improve decoding accuracy of the additional information.

In a possible implementation method, the decoupling the group of log-likelihood ratios based on the decoding result of the additional information, to obtain a decoding result of a first codeword corresponding to the group of log-likelihood ratios includes: decoupling the second part of the group of log-likelihood ratios based on the decoding result of the additional information and the first part of the group of log-likelihood ratios, to obtain decoupling information of the group of log-likelihood ratios; and decoding the decoupling information of the group of log-likelihood ratios to obtain the decoding result of the first codeword corresponding to the group of log-likelihood ratios.

In the foregoing solution, the second part of the group of likelihood ratios is first decoupled based on the decoding result of the additional information, to obtain the decoupling information of the group of log-likelihood ratios, and then the decoupling information of the group of log-likelihood ratios is decoded to obtain the decoding result of the first codeword corresponding to the group of log-likelihood ratios, thereby improving decoding accuracy of the first codeword.

In a possible implementation method, the group of log-likelihood ratios is $L^i$ and $L^i = \{l^i_0, l^i_1, l^i_2, \ldots, l^i_{M^i-1}\}$, the decoupling information of the group of log-likelihood ratios is $Q^i$ and $Q^i = \{q^i_0, q^i_1, q^i_2, \ldots, q^i_{M^i-1}\}$, the decoding result of the additional information is Ý and Ý = $\{\acute{y}_0, \acute{y}_1, \ldots \acute{y}_{N'-1}, \}$, i=0, 1, 2, ..., m-1, $M^i$ represents a quantity of element values of $L^i$ and a quantity of element values of $Q^i$, $N^i$ represents a quantity of element values of a first part of $Q^i$, and N' represents a quantity of element values of Ý;

the first part of $Q^i$ is generated by using the following method:

$$\text{for}(j=0;\ j<N^i;\ j=j+1)$$

$$q^i_j = l^i_j;$$

and

a second part of $Q^i$ is generated by using the following method:

$$\text{for}(j=N^i;\ j<M^i;\ j=j+1)$$

$$q^i_{mod(j,N^i)} = G(l^i_{mod(j-N^i+\Delta^i,N')},\ q^i_{mod(j,N^i)}, \acute{y}_{mod(j-N^i+\Delta^i,N')}),$$

where

mod represents a modulo operation, $\Delta^i$ represents a coupling sequence number offset value of the additional information, and the function G represents a feedback decoupling log-likelihood ratio combination operation function.

In a possible implementation method, the group of log-likelihood ratios is $L^i$ and $L^i = \{l^i_0, l^i_1, l^i_2, \ldots, l^i_{M^i-1}\}$, the log-likelihood ratio of the additional information is $Z^i$ and $Z^i = \{z^i_0, z^i_1, z^i_2, \ldots, z^i_{N'-1}\}$, i=0, 1, 2, ..., m-1, N' represents a quantity of element values of $Z^i$, and $M^i$ represents a quantity of element values of the any group of log-likelihood ratios;

the log-likelihood ratio of the additional information is generated by using the following method:

$$\text{for}(j=N^i;\ j<M^i;\ j=j+1)$$

$$z^i_{mod(j-N^i+\Delta^i,N')} = z^i_{mod(j-N^i+\Delta^i,N')} + F(l^i_j, l^i_{mod(j,N^i)}),$$

where

mod represents a modulo operation, F represents a log-likelihood ratio decoupling operation function, and $\Delta^i$ represents a coupling sequence number offset value of the additional information.

In a possible implementation method, $\Delta^i = i * mod\left(\sum_{i=0}^{m-1}(E^i - N^i), N'\right)$, where $\Sigma$ represents a summation operation.

In the foregoing solution, a manner of coupling the additional information with the second codeword may be flexibly set, and specifically, a mapping relationship between the element value of the additional information and the element value of the second codeword for performing an exclusive OR operation may be flexibly selected.

In a possible implementation method, the sum value of the log-likelihood ratios that are of the additional information and that respectively correspond to the m groups of log-likelihood ratios is Z and $Z = \sum_{i=0}^{m-1} Z^i$. represents a log-likelihood ratio that is of the additional information and that corresponds to an $i^{th}$ group of log-likelihood ratios.

In a possible implementation method, the first codeword is a polar code.

According to a third aspect, an embodiment of this application provides a communication apparatus. The apparatus has a function of implementing any implementation method of the first aspect and the second aspect. The function may be implemented by hardware, or may be implemented by hardware executing corresponding software. The hardware or the software includes one or more modules corresponding to the function.

According to a fourth aspect, an embodiment of this application provides a communication apparatus, including a processor coupled to a memory. The processor is configured to invoke a program stored in the memory, to perform any implementation method of the first aspect and the second aspect. The memory may be located inside or outside the apparatus. In addition, there may be one or more processors.

According to a fifth aspect, an embodiment of this application provides a communication apparatus, including a processor and a memory. The memory is configured to store computer instructions. When the apparatus runs, the processor executes the computer instructions stored in the memory, to enable the apparatus to perform any implementation method of the first aspect and the second aspect.

According to a sixth aspect, an embodiment of this application provides a communication apparatus, including a unit or means (means) configured to perform steps of any implementation method of the first aspect and the second aspect.

According to a seventh aspect, an embodiment of this application provides a communication apparatus, including a processor and an interface circuit. The processor is configured to: communicate with another apparatus through the interface circuit, and perform any implementation method of the first aspect and the second aspect. There are one or more processors.

According to an eighth aspect, an embodiment of this application further provides a computer-readable storage medium. The computer-readable storage medium stores instructions, and when the instructions are run on a communication apparatus, any implementation method of the first aspect and the second aspect is performed.

According to a ninth aspect, an embodiment of this application further provides a computer program product. The computer program product includes a computer program or instructions. When the computer program or the instructions are run by a communication apparatus, any implementation method of the first aspect and the second aspect is performed.

According to a tenth aspect, an embodiment of this application further provides a chip system, including a processor, configured to perform any implementation method of the first aspect and the second aspect.

According to an eleventh aspect, an embodiment of this application further provides a communication system. The communication system includes a first apparatus configured to perform any implementation method of the first aspect and a second apparatus configured to perform any implementation method of the first aspect.

## BRIEF DESCRIPTION OF DRAWINGS

FIG. 1 is a diagram of a communication system to which an embodiment of this application is applicable;
FIG. 2 is a schematic flowchart of a communication method according to an embodiment of this application;
FIG. 3 is a schematic flowchart of a communication method according to an embodiment of this application;
FIG. 4 is an example diagram of coupling additional information to a PDCCH according to an embodiment of this application;
FIG. 5 is a diagram of a communication apparatus according to an embodiment of this application; and
FIG. 6 is a diagram of a communication apparatus according to an embodiment of this application.

DESCRIPTION OF EMBODIMENTS

FIG. 1 is a diagram of a communication system to which an embodiment of this application is applicable. The communication system includes a first apparatus and a second apparatus. When the first apparatus is used as a sending device, the second apparatus is used as a receiving device. When the second apparatus is used as a sending device, the first apparatus is used as a receiving device. Specific implementations of the first apparatus and the second apparatus are not limited in embodiments of this application.

For ease of description, in this application, an example in which the first apparatus is a sending device and the second apparatus is a receiving device is used for description.

For example, the first apparatus is a terminal device or a chip in the terminal device, and the second apparatus is also a terminal device or a chip in the terminal device. For another example, the first apparatus is a terminal device or a chip in the terminal device, and the second apparatus is a network device or a chip in the network device. For another example, the first apparatus is a network device or a chip in the network device, and the second apparatus is also a network device or a chip in the network device.

In embodiments of this application, the terminal device may be a device having a wireless transceiver function, and may be specifically user equipment (user equipment, UE), an access terminal, a subscriber unit (subscriber unit), a subscriber station, a mobile station (mobile station), a remote station, a remote terminal, a mobile device, a user terminal, a wireless communication device, a user agent, or a user apparatus. The terminal device may be deployed on land, and includes an indoor device, an outdoor device, a handheld device, or a vehicle-mounted device; may be deployed on water (for example, on a ship); or may be deployed in air (for example, on a plane, a balloon, or a satellite). The terminal device may be a cellular phone, a mobile phone (mobile phone), a tablet computer (pad), a wireless data card, a wireless modem, a satellite terminal, a vehicle-mounted device, a wearable device, an unmanned aerial vehicle, a robot, a smart point of sale (point of sale, POS) machine, a customer-premises equipment (customer-premises equipment, CPE), a computer having a wireless transceiver function, a virtual reality (virtual reality, VR) terminal device, an augmented reality (augmented reality, AR) terminal device, a terminal device in industrial control (industrial control), a terminal device in self driving (self driving), a terminal device in remote medical (remote medical), a terminal device in a smart grid (smart grid), a terminal in transportation safety (transportation safety), a terminal device in a smart city (smart city), and a terminal in smart home (smart home).

In embodiments of this application, the network device is a device having a wireless transceiver function, and is configured to communicate with the terminal device; or may be a device that can connect the terminal device to a wireless network, for example, a radio access network (radio access network, RAN) device or a node. In embodiments of this application, the network device may include various forms of base stations, for example, a macro base station, a micro base station (also referred to as a small cell), a relay station, an access point, a device that implements a base station function in a communication system evolved after a fifth generation (5th generation, 5G) communication system, an access point (access point, AP) in a wireless fidelity (wireless fidelity, Wi-Fi) system, an integrated access and backhaul (integrated access and backhaul, IAB) node, a transmission and reception point (transmitting and receiving point, TRP), a transmission point (transmitting point, TP), a mobile switching center, a device that undertakes a base station function in device-to-device (Device-to-Device, D2D), vehicle-to-everything (vehicle-to-everything, V2X), and machine-to-machine (machine-to-machine, M2M) communication; may further include a central unit (central unit, CU) and a distributed unit (distributed unit, DU) in a cloud radio access network (cloud radio access network, C-RAN) system, and a network device in a non-terrestrial communication network (non-terrestrial network, NTN) communication system, that is, may be deployed on a high-altitude platform or a satellite; or may be various devices that constitute an access node, such as an active antenna processing unit (active antenna unit, AAU) and a baseband unit (baseband unit, BBU). This is not limited in embodiments of this application.

FIG. 2 is a schematic flowchart of a communication method according to an embodiment of this application. The method is executed by a first apparatus, and the method describes an encoding process of the first apparatus. The method includes the following steps.

Step 201: The first apparatus respectively encodes m first codewords to obtain m second codewords, where m is a positive integer.

The first codeword herein may be a polar code or a code of another type. This is not limited in this application.

The second codeword is obtained by repeating the first codeword, that is, the first codeword is used as a mother code, and the mother code is repeatedly encoded to obtain the second codeword.

It is assumed that the m first codewords are $X^0$, $X^1$, ..., and $X^{m-1}$, and quantities of elements in $X^0$, $X^1$, ..., and $X^{m-1}$ are respectively $N^0$, $N^1$, ..., and $N^{m-1}$. An (i+1)$^{th}$ first codeword is $X^i=\{x_0^i, x_1^i, x_2^i, \dots, x_{N^i-1}^i\}$, and i=0, 1, 2, ..., m-1. $N^i$ indicates a quantity of element values of $X^i$.

The (i+1)$^{th}$ first codeword $X^i$ is used as an example. The element value in $X^i$ is repeated, to obtain a second codeword corresponding to $X^i$. For example, a second codeword corresponding to $X^i$ is

$\{x_0^i, x_1^i, x_2^i, \ldots, x_{N^i-1}^i, x_0^i, x_1^i, x_2^i, \ldots, x_{N^i-1}^i\}$. . For another example, a second codeword corresponding to $X^i$ is $\{x_0^i, x_1^i, x_2^i, \ldots, x_{N^i-1}^i, x_0^i, x_1^i, x_2^i, \ldots, x_{N^i-1}^i, x_0^i, x_1^i, x_2^i, \ldots, x_{N^i-1}^i\}$. For another example, a second codeword corresponding to $X^i$ is $\{x_0^i, x_1^i, x_2^i, \ldots, x_{N^i-1}^i, x_0^i, x_1^i, x_2^i, \ldots, x_{N^i-1}^i, x_0^i, x_1^i, x_2^i\}$. For another example, a second codeword corresponding to $X^i$ is $\{x_0^i, x_1^i, x_2^i, \ldots, x_{N^i-1}^i, x_0^i, x_1^i, x_2^i, \ldots, x_{N^i-1}^i, x_0^i, x_1^i, x_2^i, x_3^i, x_4^i, x_6^i\}$, and the like. To be specific, each element value in $X^i$ is repeated once or more times to obtain a corresponding second codeword.

A corresponding second codeword may be obtained for each first codeword in the m first codewords, and second codewords corresponding to different first codewords may have a same length or may have different lengths. Therefore, the m first codewords correspond to the m second codewords.

Step 202: The first apparatus separately couples additional information with the m second codewords to obtain m coupled codes.

The additional information in this embodiment of this application is information that needs to be additionally sent in addition to information that is of the m second codewords and that is sent by the first apparatus to a second apparatus. The additional information is coupled with the m second codewords for sending, so that channel throughput performance can be improved. Specific content of the additional information is not limited in embodiments of this application, and may be any type of information. The additional information and the first codeword may be codewords of a same type, for example, both are polar codes, or may be codewords of different types. This is not limited herein.

In an implementation method, the additional information is divided into m pieces of sub-information, and then each piece of sub-information is coupled with one second codeword in the m second codewords, to obtain the m coupled codes. For example, a 1st piece of sub-information is coupled with a 1st second codeword to obtain a 1st coupled code, a 2nd piece of sub-information is coupled with a 2nd second codeword to obtain a 2nd coupled code, ..., and by analogy. The m coupled codes are obtained in total.

In still another implementation method, same additional information is coupled to m second additional codes to obtain the m coupled codes, that is, the additional information coupled in the m coupled codes is the same.

For ease of description, this embodiment of this application is described by using an example in which the same additional information is coupled in the m coupled codes.

It is assumed that the m coupled codes corresponding to the m second codewords are $E^0$, $E^1$, ..., and $E^{m-1}$, and quantities of element values in $E^0$, $E^1$, ..., and $E^{m-1}$ are respectively $M^0$, $M^1$, ..., and $M^{m-1}$. $E^0$ corresponds to $X^0$, $E^1$ corresponds to $X^1$, ..., and $E^{m-1}$ corresponds to $X^{m-1}$. $M^0>N^0$, $M^1>N^1$, ..., and $M^{m-1}>N^{m-1}$. An (i+1)th coupled code is $E^i=\{e_0^i, e_1^i, e_2^i, \ldots, e_{M^i-1}^i\}$, and i=0, 1, ..., m-1.

Each coupled code includes two parts: a first part and a second part, where the first part is the same as a first codeword that is in the m first codewords and that corresponds to the coupled code, and the second part is obtained by coupling the additional information with a second codeword that is in the m second codewords and that corresponds to the coupled code. For example, each element value of the second part is obtained by performing an exclusive OR operation on each element value in the additional information and each element value in a corresponding second codeword except the first codeword.

It is assumed that the additional information is Y and Y=$\{y_0, y_1, y_2, \ldots, y_{N'-1}\}$, and $N'$ indicates a quantity of element values in Y.

In an implementation method, a relationship between $E^i$, $X^i$, and Y is as follows:

a first part of $E^i$ is $\{e_0^i, e_1^i, e_2^i, \ldots e_{N^i-1}^i\}$, and the first part is generated by using the following method:

$$\text{for}(j=0;\ j<N^i;\ j=j+1)$$

$$e_j^i = x_j^i;$$

and

a second part of $E^i$ is $\{e_{N^i}^i, e_{N^i+1}^i, e_{N^i+2}^i, \ldots e_{M^i-1}^i\}$, and the second part is generated by using the following method:

$$\text{for}(j=N^i;\ j<M^i;\ j=j+1)$$

$$e_j^i = x_{mod(j,N^i)}^i \hat{} y_{mod(j-N^i+\Delta^i,N')},$$

where

mod represents a modulo operation, ^ represents an exclusive OR operation, and $\Delta^i$ represents a coupling sequence number offset value of the additional information.

For example, $\Delta^i = i * mod\left(\sum_{i=0}^{m-1}(M^i - N^i), N'\right)$, where $\Sigma$ represents a summation operation.

Certainly, the foregoing merely provides an example of an implementation method for coupling the additional information Y to each second codeword. In actual application, the foregoing coupling method is not limited.

Step 203: The first apparatus sends the m coupled codes.

Specifically, the first apparatus sends the m coupled codes to the second apparatus.

It should be noted that, the first apparatus may send a coupled code each time the coupled code is generated, and does not need to uniformly send the m coupled codes after all the m coupled codes are generated. Certainly, the m coupled codes may alternatively be uniformly sent after all the m coupled codes are generated. A specific method for sending the m coupled codes is not limited in embodiments of this application.

In the foregoing solution, the additional information is coupled with the m second codewords to obtain the m coupled codes, and the m coupled codes are transmitted. After the additional information in the m coupled codes is decoupled, transmission effect that is the same as or similar to that of merely transmitting the m second codewords may be obtained. In this way, more information can be sent additionally without changing a decoding rate of the second codeword, and channel performance is improved.

FIG. 3 is a schematic flowchart of a communication method according to an embodiment of this application. The method is executed by a second apparatus, and the method describes a decoding process of the second apparatus. The method includes the following steps.

Step 301: The second apparatus receives m groups of log-likelihood ratios (log-likelihood ratio, LLR).

After the first apparatus sends the m coupled codes by using the method in the embodiment in FIG. 2, the second apparatus may receive the m groups of log-likelihood ratios, where the m groups of log-likelihood ratios one-to-one correspond to the m coupled codes. For example, a 1st group of log-likelihood ratios corresponds to a 1st coupled code, a 2nd group of log-likelihood ratios corresponds to a 2nd coupled code, and by analogy.

A quantity of element values in each group of log-likelihood ratios is the same as a quantity of element values in a coupled code corresponding to the group of log-likelihood ratios.

One group of log-likelihood ratios is also referred to as one group of received soft values.

Step 302: The second apparatus decodes the m groups of log-likelihood ratios to obtain a decoding result of additional information and a decoding result of m first codewords.

In a possible implementation method, for one group of log-likelihood ratios in the m groups of log-likelihood ratios, the second apparatus decouples a second part of the group of log-likelihood ratios based on a first part of the group of log-likelihood ratios, to obtain a log-likelihood ratio of the additional information, where a quantity of element values in the first part of the group of log-likelihood ratios is equal to a quantity of element values in a first part of a coupled code that is in the m coupled codes and that corresponds to the group of log-likelihood ratios, and a quantity of element values in the second part of the group of log-likelihood ratios is equal to a quantity of element values in a second part of the coupled code that is in the m coupled codes and that corresponds to the group of log-likelihood ratios; then determines the decoding result of the additional information based on log-likelihood ratios that are of the additional information and that respectively correspond to the m groups of log-likelihood ratios; and decouples the group of log-likelihood ratios based on the decoding result of the additional information, to obtain a decoding result of a first codeword corresponding to the group of log-likelihood ratios.

In an implementation method, that the second apparatus determines the decoding result of the additional information based on log-likelihood ratios that are of the additional information and that respectively correspond to the m groups of log-likelihood ratios may be, for example, that the second apparatus first determines a sum value of the log-likelihood ratios that are of the additional information and that respectively correspond to the m groups of log-likelihood ratios, and then decodes the sum value to obtain the decoding result of the additional information. In this method, m log-likelihood ratios of the additional information are first obtained through decoding, and then the m log-likelihood ratios are summed up and decoded to obtain the decoding result of the additional information. This helps improve decoding accuracy of the additional information.

In a possible implementation method, that the second apparatus decouples the group of log-likelihood ratios based on the decoding result of the additional information, to obtain a decoding result of a first codeword corresponding to

the group of log-likelihood ratios may be, for example, that the second apparatus decouples the second part of the group of log-likelihood ratios based on the decoding result of the additional information and the first part of the group of log-likelihood ratios, to obtain decoupling information of the group of log-likelihood ratios, and decodes the decoupling information of the group of log-likelihood ratios to obtain the decoding result of the first codeword corresponding to the group of log-likelihood ratios. In this method, the second part of the group of likelihood ratios is first decoupled based on the decoding result of the additional information, to obtain the decoupling information of the group of log-likelihood ratios, and then the decoupling information of the group of log-likelihood ratios is decoded to obtain the decoding result of the first codeword corresponding to the group of log-likelihood ratios, thereby improving decoding accuracy of the first codeword.

It is assumed that the m groups of log-likelihood ratios are $L^0$, $L^1$, ..., and $L^{m-1}$, where $L^i = \{l_0^i, l_1^i, l_2^i, \ldots, l_{M^i-1}^i\}$ represents an (i+1)th group of log-likelihood ratios in the m groups of log-likelihood ratios, and i=0, 1, 2, ..., m-1. $M^i$ indicates a quantity of element values of $L^i$. $L^i$ corresponds to $X^i$ and $E^i$.

In an implementation method, it is assumed that a log-likelihood ratio that is of the additional information and that corresponds to the (i+1)th group of log-likelihood ratios $L^i$ is $Z^i$ and $Z^i=\{z_0^i, z_1^i, z_2^i, \ldots, z_{N'-1}^i\}$, i=0, 1, 2, ..., m-1, and $N'$ represents a quantity of element values of $Z^i$. In this case, the following method may be used to generate $Z^i$:

$$\mathrm{for}(j=N^i;\ j<M^i;\ j=j+1)$$

$$z^i_{\mathrm{mod}(j-N^i+\Delta^i,N')} = z^i_{\mathrm{mod}(j-N^i+\Delta^i,N')} + F(l^i_j, l^i_{\mathrm{mod}(j,N^i)}),$$

where

mod represents a modulo operation, and $\Delta^i$ represents a coupling sequence number offset value of the additional information. An initial value of each element in $Z^i$ is set to 0. F represents a log-likelihood ratio decoupling operation function. Specifically, F(L0,L1)=(sig(L0)^sig(L1)?-1:1)*(abs(L0)>abs(L1)?abs(L1):abs(L0)), where L0 and L1 are input values of the function F. sig is a sign obtaining operation. If L0 is greater than 0, sig(L0) is equal to 0; otherwise, sig(L0) is equal to 1. If L1 is greater than 0, sig(L1) is equal to 0; otherwise, sig(L1) is equal to 1. If a result of sig(L0)^sig(L1) is 0, a value of (sig(L0)^sig(L1)?-1:1) is -1. If the result of sig(L0)^sig(L1) is 1, the value of (sig(L0)^sig(L1)?-1:1) is 1. abs is a function for obtaining an absolute value. ^ indicates an exclusive OR operation.

After the m groups of log-likelihood ratios of the additional information are obtained, the m groups of log-likelihood ratios may be summed up to obtain a sum value Z and $Z=\sum_{i=0}^{m-1} Z^i$, and then the sum value Z is decoded to obtain decoded information Ý of the additional information Y and $\acute{Y} = \{\acute{y}_0, \acute{y}_1, \ldots \acute{y}_{N'-1}\}$.

After the decoding information Ý of the additional information Y is obtained, each group of log-likelihood ratios is decoupled based on Ý, to obtain decoupling information of each group of log-likelihood ratios. It is assumed that decoupling information of the (i+1)th group of log-likelihood ratios is $Q^i$ and $Q^i = \{q_0^i, q_1^i, q_2^i, \ldots, q_{M^i-1}^i\}$, and the decoding result of the additional information is Y, i=0, 1, 2, ..., m-1, $M^i$ represents a quantity of element values of $Q^i$, $N^i$ represents a quantity of element values of a first part of $Q^i$, and $N'$ represents a quantity of element values of Ý.

The first part of $Q^i$ is $\{q_0^i, q_1^i, q_2^i, \ldots, q_{N^i-1}^i\}$, and is generated by using the following method:

$$\mathrm{for}(j=0;\ j<N^i;\ j=j+1)$$

$$q^i_j = l^i_j;$$

and

a second part of $Q^i$ is $\{q_{N^i}^i, q_1^i, q_2^i, \ldots, q_{M^i-1}^i\}$, and is generated by using the following method:

$$\mathrm{for}(j=N^i;\ j<M^i;\ j=j+1)$$

$$q^i_{mod(j,N^i)} = G(l^i_{mod(j-N^i+\Delta^i,N')},\ q^i_{mod(j,N^i)}, \acute{y}_{mod(j-N^i+\Delta^i,N')}),$$

where

mod represents a modulo operation, and $\Delta^i$ represents a coupling sequence number offset value of the additional information. For a meaning of $\Delta^i$, refer to the description of the embodiment in FIG. 3. Details are not described again. The function G represents a feedback decoupling log-likelihood ratio combination operation function. Specifically, G (L0,L1,B)=(B==0)?(L1+L0):(L1-L0), where L0, L1, and B are input values of the function G. If B is equal to 0, a value of the function G is L1+L0. If B is not equal to 0, the value of the G function is L1-L0.

After the decoupling information of each group of log-likelihood ratios is obtained, the decoupling information of each group of log-likelihood ratios may be decoded to obtain decoding information of each coupled code. For example, if $\acute{X}^i$ represents decoding information of $X^i$, decoding information $\acute{X}^0$, $X^1$, ..., and $\acute{X}^{m-1}$ of $X^0$, $X^1$, ..., and $X^{m-1}$ may be obtained.

It should be noted that, during decoding, the second apparatus may perform a decoupling operation before receiving a group of log-likelihood ratios, and decouple the group of log-likelihood ratios to obtain a log-likelihood ratio of the additional information, instead of performing a decoupling operation after receiving the m groups of log-likelihood ratios. Certainly, the second apparatus may alternatively uniformly perform the decoupling operation after receiving the m groups of log-likelihood ratios. This is not limited in embodiments of this application.

In the foregoing solution, the additional information is coupled with the m second codewords to obtain the m coupled codes, and the m coupled codes are transmitted. After the additional information in the m coupled codes is decoupled, transmission effect that is the same as or similar to that of merely transmitting the m second codewords may be obtained. In this way, more information can be sent additionally without changing a decoding rate of the second codeword, and channel throughput performance is improved.

For example, the following provides a specific application of this embodiment. FIG. 4 is an example diagram of coupling additional information to a PDCCH according to an embodiment of this application. It is assumed that there is coding information of m segments of physical downlink control channels (physical downlink control channel, PDCCH), which are a PDCCH 1, a PDCCH 2, ..., and a PDCCH m, and lengths of the m segments of PDCCHs are all N. The coding information of the m segments of PDCCHs is m first codewords. The coding information of the segments of PDCCHs is repeated once to obtain m second codewords. Then, additional information Y is separately coupled to second parts of the second codewords to obtain m coupled codes. The additional information Y includes one or more of the following information: an aggregation level, a user ID corresponding to each PDCCH, and an information length of each PDCCH. A base station sends the m coupled codes through broadcast, and all a plurality of UEs can receive the m coupled codes.

If the additional information Y includes the user ID corresponding to each PDCCH, for specific UE, after receiving the m coupled codes, the UE first decodes the m coupled codes to obtain additional information A. If it is found that an ID of the UE does not appear in the additional information A, subsequent decoding may be abandoned; otherwise, coding information of a corresponding specific segment of the PDCCH continues to be decoded. The method can reduce a quantity of decoding times, that is, reduce a quantity of blind detection times.

If the additional information Y includes the information length of each PDCCH, for specific UE, after receiving the m coupled codes, the UE first decodes the m coupled codes to obtain additional information A, so as to obtain the information length of each PDCCH. Subsequently, the PDCCH may be decoded once based on the information length of each PDCCH, and there is no need to attempt to decode the PDCCH based on a plurality of information lengths, so that a quantity of blind detection times can be reduced.

If the additional information Y includes the aggregation level, for specific UE, after receiving the m coupled codes, the UE first decodes the m coupled codes to obtain the additional information A, so as to obtain the aggregation level. Subsequently, the PDCCH may be decoded based on the aggregation level, and there is no need to attempt to decode the PDCCH at a plurality of aggregation levels, so that a quantity of blind detection times can be reduced.

It may be understood that, to implement the functions in the foregoing embodiments, the first apparatus or the second apparatus includes corresponding hardware structures and/or software modules for performing the functions. A person skilled in the art should be easily aware that, in this application, the units and method steps in the examples described with reference to embodiments disclosed in this application can be implemented by hardware or a combination of hardware and computer software. Whether a function is performed by hardware or hardware driven by computer software depends on particular application scenarios and design constraints of the technical solutions.

FIG. 5 and FIG. 6 are diagrams of structures of possible communication apparatuses according to embodiments of this application. These communication apparatuses may be configured to implement the function of the first apparatus or the second apparatus in the foregoing method embodiments, and therefore may also implement beneficial effect of the foregoing method embodiments. In this embodiment of this application, the communication apparatus may be the first apparatus or the second apparatus shown in FIG. 1.

A communication apparatus 500 shown in FIG. 5 includes a processing unit 510 and a transceiver unit 520. The communication apparatus 500 is configured to implement the function of the first apparatus or the second apparatus in the foregoing method embodiments.

When the communication apparatus 500 is configured to implement the function of the first apparatus in the

foregoing method embodiments, the processing unit 510 is configured to: respectively encode m first codewords to obtain m second codewords, where the second codeword is obtained by repeating the first codeword, and m is a positive integer; and separately couple additional information with the m second codewords to obtain m coupled codes, where the coupled code includes a first part and a second part, the first part is the same as a first codeword that is in the m first codewords and that corresponds to the coupled code, and the second part is obtained by coupling the additional information with a second codeword that is in the m second codewords and that corresponds to the coupled code; and the transceiver unit 520 is configured to send the m coupled codes.

In a possible implementation method, each element value of the second part is obtained by performing an exclusive OR operation on each element value in the additional information and each element value in the second codeword except the first codeword.

In a possible implementation method, an (i+1)th first codeword in the m first codewords is $X^i$ and $X^i=\{x_0^i, x_1^i, x_2^i, \dots, x_{N^i-1}^i\}$, an (i+1)th coupled code in the m coupled codes is $E^i$ and $E^i=\{e_0^i, e_1^i, e_2^i, \dots, e_{M^i-1}^i\}$, the additional information is Y and Y=$\{y_0, y_1, y_2, \dots, Y_{N'-1}\}$, i=0, 1, 2, ..., m-1, $N^i$ represents a quantity of element values of $X^i$, $M^i$ represents a quantity of element values of $E^i$, and N' represents a quantity of element values of Y;

a first part of $E^i$ is $\{e_0^i, e_1^i, e_2^i, \dots e_{N^i-1}^i\}$, and the first part is generated by using the following method:

$$\text{for}(j=0;\ j<N^i;\ j=j+1)$$

$$e_j^i = x_j^i;$$

and

a second part of $E^i$ is $\{e_{N^i}^i, e_{N^i+1}^i, e_{N^i+2}^i, \dots e_{M^i-1}^i\}$, and the second part is generated by using the following method:

$$\text{for}(j=N^i;\ j<M^i;\ j=j+1)$$

$$e_j^i = x_{mod(j,N^i)}^i \wedge y_{mod(j-N^i+\Delta^i,N')},$$

where

mod represents a modulo operation, ^ represents an exclusive OR operation, and $\Delta^i$ represents a coupling sequence number offset value of the additional information.

In a possible implementation method, $\Delta^i = i * mod\left(\sum_{i=0}^{m-1}(M^i - N^i), N'\right)$, where Σ represents a summation operation.

In a possible implementation method, additional information coupled in the m coupled codes is the same.

In a possible implementation method, the first codeword is a polar code.

When the communication apparatus 500 is configured to implement the function of the second apparatus in the foregoing method embodiments, the transceiver unit 520 is configured to receive m groups of log-likelihood ratios, where the m groups of log-likelihood ratios one-to-one correspond to m coupled codes, the m coupled codes one-to-one correspond to m second codewords, the m second codewords are obtained by repeatedly encoding m first codewords respectively, and m is a positive integer; and the processing unit 510 is configured to decode the m groups of log-likelihood ratios to obtain a decoding result of additional information and a decoding result of the m first codewords, where the coupled code includes a first part and a second part, the first part is the same as a first codeword that is in the m first codewords and that corresponds to the coupled code, and the second part is obtained by coupling the additional information with a second codeword that is in the m second codewords and that corresponds to the coupled code.

In a possible implementation method, the processing unit 510 is specifically configured to: for one group of log-likelihood ratios in the m groups of log-likelihood ratios, decouple a second part of the group of log-likelihood ratios based on a first part of the group of log-likelihood ratios, to obtain a log-likelihood ratio of the additional information, where a

quantity of element values in the first part of the group of log-likelihood ratios is equal to a quantity of element values in a first part of a coupled code that is in the m coupled codes and that corresponds to the group of log-likelihood ratios, and a quantity of element values in the second part of the group of log-likelihood ratios is equal to a quantity of element values in a second part of the coupled code that is in the m coupled codes and that corresponds to the group of log-likelihood ratios; determine the decoding result of the additional information based on log-likelihood ratios that are of the additional information and that respectively correspond to the m groups of log-likelihood ratios; and decouple the group of log-likelihood ratios based on the decoding result of the additional information, to obtain a decoding result of a first codeword corresponding to the group of log-likelihood ratios.

In a possible implementation method, the processing unit 510 is specifically configured to: determine a sum value of the log-likelihood ratios that are of the additional information and that respectively correspond to the m groups of log-likelihood ratios; and decode the sum value to obtain the decoding result of the additional information.

In a possible implementation method, the processing unit 510 is specifically configured to: decouple the second part of the group of log-likelihood ratios based on the decoding result of the additional information and the first part of the group of log-likelihood ratios, to obtain decoupling information of the group of log-likelihood ratios; and decode the decoupling information of the group of log-likelihood ratios to obtain the decoding result of the first codeword corresponding to the group of log-likelihood ratios.

In a possible implementation method, the group of log-likelihood ratios is $L^i$ and $L^i = \{\mathrm{l}_0^\mathrm{i}, \mathrm{l}_1^\mathrm{i}, \mathrm{l}_2^\mathrm{i}, \ldots, \mathrm{l}_{\mathrm{M}^\mathrm{i}-1}^\mathrm{i}\}$, the decoupling information of the group of log-likelihood ratios is $Q^i$ and $Q^i = \{q_0^i, q_1^i, q_2^i, \ldots, q_{M^i-1}^i\}$, the decoding result of the additional information is Ý and Ý = $\{\acute{y}_0, \acute{y}_1, \ldots \acute{y}_{N'-1}, \}$, i=0, 1, 2, ..., m-1, $M^i$ represents a quantity of element values of $L^i$ and a quantity of element values of $Q^i$, $N^i$ represents a quantity of element values of a first part of $Q^i$, and N' represents a quantity of element values of Ý;

the first part of $Q^i$ is generated by using the following method:

$$\mathrm{for(j=0;\ j<N^i;\ j=j+1)}$$

$$\mathrm{q_j^i = l_j^i;}$$

and

a second part of $Q^i$ is generated by using the following method:

$$\mathrm{for(j=N^i;\ j<M^i;\ j=j+1)}$$

$$q_{mod(j,N^i)}^i = G(l_{mod(j-N^i+\Delta^i,N')}^i,\ q_{mod(j,N^i)}^i, \acute{y}_{mod(j-N^i+\Delta^i,N')}),$$

where

mod represents a modulo operation, $\Delta^i$ represents a coupling sequence number offset value of the additional information, and the function G represents a feedback decoupling log-likelihood ratio combination operation function.

In a possible implementation method, the group of log-likelihood ratios is $L^i$ and $L^i = \{\mathrm{l}_0^\mathrm{i}, \mathrm{l}_1^\mathrm{i}, \mathrm{l}_2^\mathrm{i}, \ldots, \mathrm{l}_{\mathrm{M}^\mathrm{i}-1}^\mathrm{i}\}$, the log-likelihood ratio of the additional information is $Z^i$ and $Z^i = \{\mathrm{z}_0^i, \mathrm{z}_1^i, \mathrm{z}_2^i, \ldots, \mathrm{z}_{N'-1}^i\}$, i=0, 1, 2, ..., m-1, $N'$ represents a quantity of element values of $Z^i$, and $M^i$ represents a quantity of element values of the any group of log-likelihood ratios;

the log-likelihood ratio of the additional information is generated by using the following method:

$$\mathrm{for(j=N^i;\ j<M^i;\ j=j+1)}$$

$$\mathrm{z_{mod(j-N^i+\Delta^i,N')}^i = z_{mod(j-N^i+\Delta^i,N')}^i + F(l_j^i, l_{mod(j,N^i)}^i)},$$

where

mod represents a modulo operation, F represents a log-likelihood ratio decoupling operation function, and $\Delta^i$ represents a coupling sequence number offset value of the additional information.

In a possible implementation method, $\Delta^i = i * mod\left(\sum_{i=0}^{m-1}(E^i - N^i), N'\right)$, where $\Sigma$ represents a summation operation.

In a possible implementation method, the sum value of the log-likelihood ratios that are of the additional information and that respectively correspond to the m groups of log-likelihood ratios is Z and $Z = \sum_{i=0}^{m-1} Z^i$. $Z^i$ represents a log-likelihood ratio that is of the additional information and that corresponds to an $i^{th}$ group of log-likelihood ratios.

In a possible implementation method, the first codeword is a polar code.

For more detailed descriptions about the processing unit 510 and the transceiver unit 520, directly refer to related descriptions in the foregoing method embodiments. Details are not described herein again.

As shown in FIG. 6, a communication apparatus 600 includes a processor 610 and an interface circuit 620. The processor 610 and the interface circuit 620 are coupled to each other. It may be understood that the interface circuit 620 may be a transceiver or an input/output interface. Optionally, the communication apparatus 600 may further include a memory 630 that is configured to store instructions executed by the processor 610, store input data required by the processor 610 to run instructions, or store data generated after the processor 610 runs instructions.

When the communication apparatus 600 is configured to implement the foregoing method embodiments, the processor 610 is configured to implement a function of the processing unit 510, and the interface circuit 620 is configured to implement a function of the transceiver unit 520.

It can be understood that the processor in embodiments of this application may be a central processing unit (Central Processing Unit, CPU), or may be another general-purpose processor, a digital signal processor (Digital Signal Processor, DSP), an application-specific integrated circuit (Application-Specific Integrated Circuit, ASIC), a field programmable gate array (Field Programmable Gate Array, FPGA) or another programmable logic device, a transistor logic device, a hardware component, or any combination thereof. The general-purpose processor may be a microprocessor or any regular processor or the like.

The method steps in embodiments of this application may be implemented in a hardware manner, or may be implemented in a manner of executing software instructions by the processor. The software instructions may include a corresponding software module. The software module may be stored in a random access memory, a flash memory, a read-only memory, a programmable read-only memory, an erasable programmable read-only memory, an electrically erasable programmable read-only memory, a register, a hard disk, a removable hard disk, and a compact disc read-only memory (compact disc read-only memory, CD-ROM) or any other form of storage medium well known in the art. For example, a storage medium is coupled to a processor, so that the processor can read information from the storage medium and write information into the storage medium. Certainly, the storage medium may be a component of the processor. The processor and the storage medium may be disposed in an ASIC. In addition, the ASIC may be located in the first apparatus or the second apparatus. Certainly, the processor and the storage medium may alternatively exist in the first apparatus or the second apparatus as discrete components.

All or some of the foregoing embodiments may be implemented by using software, hardware, firmware, or any combination thereof. When software is used to implement embodiments, all or a part of embodiments may be implemented in a form of a computer program product. The computer program product includes one or more computer programs or instructions. The computer program (English: Computer Program) is a set of instructions that indicate each step of an electronic computer or another device having a message processing capability, and is usually written in a program design language and runs on a target architecture. When the computer programs or instructions are loaded and executed on a computer, all or some of the procedures or functions in embodiments of this application are performed. The computer may be a general-purpose computer, a dedicated computer, a computer network, an access network device, a terminal device, or another programmable apparatus. The computer program or instructions may be stored in a computer-readable storage medium, or may be transmitted from a computer-readable storage medium to another computer-readable storage medium. For example, the computer program or instructions may be transmitted from a website, computer, server, or data center to another website, computer, server, or data center in a wired or wireless manner. The computer-readable storage medium may be any usable medium that can be accessed by the computer, or a data storage device, for example, a server or a data center, integrating one or more usable media. The usable medium may be a magnetic medium, for example, a floppy disk, a hard disk, or a magnetic tape; or may be an optical medium, for example, a digital video disc; or may be a semiconductor medium, for example, a solid-state drive. The computer-readable storage medium may be a volatile or non-volatile storage medium, or may include two types of storage media: a volatile storage medium and a non-volatile storage medium.

In embodiments of this application, unless otherwise stated or there is a logic conflict, terms and/or descriptions in different embodiments are consistent and may be mutually referenced, and technical features in different embodiments may be combined based on an internal logical relationship thereof, to form a new embodiment.

In this application, at least one means one or more, and a plurality of means two or more. The term "and/or" describes an association relationship between associated objects, and represents that three relationships may exist. For example, A and/or B may represent the following cases: Only A exists, both A and B exist, and only B exists, where A and B may be singular or plural. In the text descriptions of this application, the character "/" represents an "or" relationship between the associated objects. In a formula in this application, the character "/" represents a "division" relationship between the associated objects.

It may be understood that various numbers in embodiments of this application are merely used for differentiation for ease of description, and are not used to limit the scope of embodiments of this application. Sequence numbers of the foregoing processes do not mean an execution sequence, and the execution sequence of the processes should be determined based on functions and internal logic of the processes.

## Claims

1. A communication method, comprising:

   respectively encoding m first codewords to obtain m second codewords, wherein the second codeword is obtained by repeating the first codeword, and m is a positive integer;
   separately coupling additional information with the m second codewords to obtain m coupled codes, wherein the coupled code comprises a first part and a second part, the first part is the same as a first codeword that is in the m first codewords and that corresponds to the coupled code, and the second part is obtained by coupling the additional information with a second codeword that is in the m second codewords and that corresponds to the coupled code; and
   sending the m coupled codes.

2. The method according to claim 1, wherein each element value of the second part is obtained by performing an exclusive OR operation on each element value in the additional information and each element value in the second codeword except the first codeword.

3. The method according to claim 2, wherein an (i+1)th first codeword in the m first codewords is $X^i$ and $X^i=\{x_0^i, x_1^i, x_2^i, \ldots, x_{N^i-1}^i\}$, an (i+1)th coupled code in the m coupled codes is $E^i$ and $E^i=\{e_0^i, e_1^i, e_2^i, \ldots, e_{M^i-1}^i\}$, the additional information is Y and Y=$\{y_0, y_1, y_2, \ldots, y_{N'-1}\}$, i=0, 1, 2, ..., m-1, $N^i$ represents a quantity of element values of $X^i$, $M^i$ represents a quantity of element values of $E^i$, and N' represents a quantity of element values of Y;

   a first part of $E^i$ is $\{e_0^i, e_1^i, e_2^i, \ldots e_{N^i-1}^i\}$, and the first part is generated by using the following method:

$$\text{for}(j=0;\ j<N^i;\ j=j+1)$$

$$e_j^i = x_j^i;$$

   and
   a second part of $E^i$ is $\{e_{N^i}^i, e_{N^i+1}^i, e_{N^i+2}^i, \ldots e_{M^i-1}^i\}$, and the second part is generated by using the following method:

$$\text{for}(j=N^i;\ j<M^i;\ j=j+1)$$

$$e_j^i = x_{mod(j,N^i)}^i \hat{}\, y_{mod(j-N^i+\Delta^i,N')},$$

wherein
mod represents a modulo operation, ^ represents an exclusive OR operation, and $\Delta^i$ represents a coupling sequence number offset value of the additional information.

**4.** The method according to claim 3, wherein

$$\Delta^i = i * mod\left(\sum_{i=0}^{m-1}(M^i - N^i), N'\right),$$

wherein
$\Sigma$ represents a summation operation.

**5.** The method according to any one of claims 1 to 4, wherein additional information coupled

**6.** The method according to any one of claims 1 to 5, wherein the first codeword is a polar code.

**7.** A communication method, comprising:

receiving m groups of log-likelihood ratios, wherein the m groups of log-likelihood ratios one-to-one correspond to m coupled codes, the m coupled codes one-to-one correspond to m second codewords, the m second codewords are obtained by repeatedly encoding m first codewords respectively, and m is a positive integer; and
decoding the m groups of log-likelihood ratios to obtain a decoding result of additional information and a decoding result of the m first codewords, wherein
the coupled code comprises a first part and a second part, the first part is the same as a first codeword that is in the m first codewords and that corresponds to the coupled code, and the second part is obtained by coupling the additional information with a second codeword that is in the m second codewords and that corresponds to the coupled code.

**8.** The method according to claim 7, wherein the decoding the m groups of log-likelihood ratios to obtain a decoding result of additional information and a decoding result of the m first codewords comprises:

for one group of log-likelihood ratios in the m groups of log-likelihood ratios, decoupling a second part of the group of log-likelihood ratios based on a first part of the group of log-likelihood ratios, to obtain a log-likelihood ratio of the additional information, wherein a quantity of element values in the first part of the group of log-likelihood ratios is equal to a quantity of element values in a first part of a coupled code that is in the m coupled codes and that corresponds to the group of log-likelihood ratios, and a quantity of element values in the second part of the group of log-likelihood ratios is equal to a quantity of element values in a second part of the coupled code that is in the m coupled codes and that corresponds to the group of log-likelihood ratios;
determining the decoding result of the additional information based on log-likelihood ratios that are of the additional information and that respectively correspond to the m groups of log-likelihood ratios; and
decoupling the group of log-likelihood ratios based on the decoding result of the additional information, to obtain a decoding result of a first codeword corresponding to the group of log-likelihood ratios.

**9.** The method according to claim 8, wherein the determining the decoding result of the additional information based on log-likelihood ratios that are of the additional information and that respectively correspond to the m groups of log-likelihood ratios comprises:

determining a sum value of the log-likelihood ratios that are of the additional information and that respectively correspond to the m groups of log-likelihood ratios; and
decoding the sum value to obtain the decoding result of the additional information.

**10.** The method according to claim 8 or 9, wherein the decoupling the group of log-likelihood ratios based on the decoding result of the additional information, to obtain a decoding result of a first codeword corresponding to the group of log-likelihood ratios comprises:

decoupling the second part of the group of log-likelihood ratios based on the decoding result of the additional information and the first part of the group of log-likelihood ratios, to obtain decoupling information of the group of log-likelihood ratios; and

decoding the decoupling information of the group of log-likelihood ratios to obtain the decoding result of the first codeword corresponding to the group of log-likelihood ratios.

**11.** The method according to claim 10, wherein the group of log-likelihood ratios is $L^i$ and $L^i = \{l_0^i, l_1^i, l_2^i, \ldots, l_{M^i-1}^i\}$, the decoupling information of the group of log-likelihood ratios is $Q^i$ and $Q^i = \{q_0^i, q_1^i, q_2^i, \ldots, q_{M^i-1}^i\}$, the decoding result of the additional information is Ý and Ý = $\{\acute{y}_0, \acute{y}_1, \ldots \acute{y}_{N'-1}, \}$, i=0, 1, 2, ..., m-1, $M^i$ represents a quantity of element values of $L^i$ and a quantity of element values of $Q^i$, $N^i$ represents a quantity of element values of a first part of $Q^i$, and N' represents a quantity of element values of Ý;

the first part of $Q^i$ is generated by using the following method:

$$\text{for}(j=0;\ j<N^i;\ j=j+1)$$

$$q_j^i = l_j^i;$$

and
a second part of $Q^i$ is generated by using the following method:

$$\text{for}(j=N^i;\ j<M^i;\ j=j+1)$$

$$q_{mod(j,N^i)}^i = G(l_{mod(j-N^i+\Delta^i,N')}^i,\ q_{mod(j,N^i)}^i, \acute{y}_{mod(j-N^i+\Delta^i,N')}),$$

wherein
mod represents a modulo operation, $\Delta^i$ represents a coupling sequence number offset value of the additional information, and the function G represents a feedback decoupling log-likelihood ratio combination operation function.

**12.** The method according to any one of claims 8 to 10, wherein the group of log-likelihood ratios is $L^i$ and $L^i = \{l_0^i, l_1^i, l_2^i, \ldots, l_{M^i-1}^i\}$, the log-likelihood ratio of the additional information is $Z^i$ and $Z^i = \{z_0^i, z_1^i, z_2^i, \ldots, z_{N'-1}^i\}$, i=0, 1, 2, ..., m-1, N' represents a quantity of element values of $Z^i$, and $M^i$ represents a quantity of element values of the any group of log-likelihood ratios;

the log-likelihood ratio of the additional information is generated by using the following method:

$$\text{for}(j=N^i;\ j<M^i;\ j=j+1)$$

$$z_{mod(j-N^i+\Delta^i,N')}^i = z_{mod(j-N^i+\Delta^i,N')}^i + F(l_j^i, l_{mod(j,N^i)}^i),$$

wherein
mod represents a modulo operation, F represents a log-likelihood ratio decoupling operation function, and $\Delta^i$ represents a coupling sequence number offset value of the additional information.

**13.** The method according to claim 11 or 12, wherein

$$\Delta^i = i * mod\left(\sum_{i=0}^{m-1}(E^i - N^i), N'\right),$$

wherein

Σ represents a summation operation.

**14.** The method according to claim 9, wherein the sum value of the log-likelihood ratios that are of the additional information and that respectively correspond to the m groups of log-likelihood ratios is Z and $Z = \sum_{i=0}^{m-1} Z^i$, wherein
$Z^i$ represents a log-likelihood ratio that is of the additional information and that corresponds to an $i^{th}$ group of log-likelihood ratios in the m groups of log-likelihood ratios.

**15.** The method according to any one of claims 7 to 14, wherein the first codeword is a polar code.

**16.** A communication apparatus, comprising:

a processing unit, configured to: respectively encode m first codewords to obtain m second codewords, wherein the second codeword is obtained by repeating the first codeword, and m is a positive integer; and separately couple additional information with the m second codewords to obtain m coupled codes, wherein the coupled code comprises a first part and a second part, the first part is the same as a first codeword that is in the m first codewords and that corresponds to the coupled code, and the second part is obtained by coupling the additional information with a second codeword that is in the m second codewords and that corresponds to the coupled code; and
a transceiver unit, configured to send the m coupled codes.

**17.** The apparatus according to claim 16, wherein each element value of the second part is obtained by performing an exclusive OR operation on each element value in the additional information and each element value in the second codeword except the first codeword.

**18.** The apparatus according to claim 17, wherein an $(i+1)^{th}$ first codeword in the m first codewords is $X^i$ and $X^i=\{x_0^i, x_1^i, x_2^i, \ldots, x_{N^i-1}^i\}$, an $(i+1)^{th}$ coupled code in the m coupled codes is $E^i$ and $E^i=\{e_0^i, e_1^i, e_2^i, \ldots, e_{M^i-1}^i\}$, the additional information is Y and Y=$\{y_0, y_1, y_2, \ldots, y_{N'-1}\}$, i=0, 1, 2, ..., m-1, $N^i$ represents a quantity of element values of $X^i$, $M^i$ represents a quantity of element values of $E^i$, and N' represents a quantity of element values of Y;

a first part of $E^i$ is $\{e_0^i, e_1^i, e_2^i, \ldots e_{N^i-1}^i\}$, and the first part is generated by using the following method:

$$\text{for}(j=0;\ j<N^i;\ j=j+1)$$

$$e_j^i = x_j^i,$$

wherein
a second part of $E^i$ is $\{e_{N^i}^i, e_{N^i+1}^i, e_{N^i+2}^i, \ldots e_{M^i-1}^i\}$, and the second part is generated by using the following method:

$$\text{for}(j=N^i;\ j<M^i;\ j=j+1)$$

$$e_j^i = x_{mod(j,N^i)}^i \wedge y_{mod(j-N^i+\Delta^i,N')},$$

wherein
mod represents a modulo operation, ^ represents an exclusive OR operation, and $\Delta^i$ represents a coupling sequence number offset value of the additional information.

**19.** The apparatus according to claim 18, wherein

$$\Delta^{i} = i * mod\left(\sum_{i=0}^{m-1}(M^{i} - N^{i}), N'\right),$$

wherein
Σ represents a summation operation.

**20.** The apparatus according to any one of claims 16 to 19, wherein additional information coupled in the m coupled codes is the same.

**21.** The apparatus according to any one of claims 16 to 20, wherein the first codeword is a polar code.

**22.** A communication apparatus, comprising:

a transceiver unit, configured to receive m groups of log-likelihood ratios, wherein the m groups of log-likelihood ratios one-to-one correspond to m coupled codes, the m coupled codes one-to-one correspond to m second codewords, the m second codewords are obtained by repeatedly encoding m first codewords respectively, and m is a positive integer; and
a processing unit, configured to decode the m groups of log-likelihood ratios to obtain a decoding result of additional information and a decoding result of the m first codewords, wherein
the coupled code comprises a first part and a second part, the first part is the same as a first codeword that is in the m first codewords and that corresponds to the coupled code, and the second part is obtained by coupling the additional information with a second codeword that is in the m second codewords and that corresponds to the coupled code.

**23.** The apparatus according to claim 22, wherein the processing unit is specifically configured to: for one group of log-likelihood ratios in the m groups of log-likelihood ratios, decouple a second part of the group of log-likelihood ratios based on a first part of the group of log-likelihood ratios, to obtain a log-likelihood ratio of the additional information, wherein a quantity of element values in the first part of the group of log-likelihood ratios is equal to a quantity of element values in a first part of a coupled code that is in the m coupled codes and that corresponds to the group of log-likelihood ratios, and a quantity of element values in the second part of the group of log-likelihood ratios is equal to a quantity of element values in a second part of the coupled code that is in the m coupled codes and that corresponds to the group of log-likelihood ratios; determine the decoding result of the additional information based on log-likelihood ratios that are of the additional information and that respectively correspond to the m groups of log-likelihood ratios; and decouple the group of log-likelihood ratios based on the decoding result of the additional information, to obtain a decoding result of a first codeword corresponding to the group of log-likelihood ratios.

**24.** The apparatus according to claim 23, wherein the processing unit is specifically configured to: determine a sum value of the log-likelihood ratios that are of the additional information and that respectively correspond to the m groups of log-likelihood ratios; and decode the sum value to obtain the decoding result of the additional information.

**25.** The apparatus according to claim 23 or 24, wherein the processing unit is specifically configured to: decouple the second part of the group of log-likelihood ratios based on the decoding result of the additional information and the first part of the group of log-likelihood ratios, to obtain decoupling information of the group of log-likelihood ratios; and decode the decoupling information of the group of log-likelihood ratios to obtain the decoding result of the first codeword corresponding to the group of log-likelihood ratios.

**26.** The apparatus according to claim 25, wherein the group of log-likelihood ratios is $L^i$ and $L^{i} = \{l_0^i, l_1^i, l_2^i, \ldots, l_{M^i-1}^i\}$, the decoupling information of the group of log-likelihood ratios is $Q^i$ and $Q^{i}=\{q_0^i, q_1^i, q_2^i, \ldots, q_{M^i-1}^i\}$, the decoding result of the additional information is Ý and Ý = $\{y'_0, y'_1, \ldots y'_{N'-1}, \}$, i=0, 1, 2, ..., m-1, $M^i$ represents a quantity of element values of $L^i$ and a quantity of element values of $Q^i$, $N^i$ represents a quantity of element values of a first part of $Q^i$, and N' represents a quantity of element values of Ý;

the first part of $Q^i$ is generated by using the following method:

$$\text{for}(j=0;\ j<N^i;\ j=j+1)$$

$$q^i_j = l^i_j,$$

wherein
a second part of $Q^i$ is generated by using the following method:

$$\text{for}(j=N^i;\ j<M^i;\ j=j+1)$$

$$q^i_{mod(j,N^i)} = G(l^i_{mod(j-N^i+\Delta^i,N')},\ q^i_{mod(j,N^i)}, \acute{y}_{mod(j-N^i+\Delta^i,N')}),$$

wherein
mod represents a modulo operation, ^ represents an exclusive OR operation, $\Delta^i$ represents a coupling sequence number offset value of the additional information, and the function G represents a feedback decoupling log-likelihood ratio combination operation function.

**27.** The apparatus according to any one of claims 23 to 25, wherein the group of log-likelihood ratios is $L^i$ and $L^i = \{l^i_0, l^i_1, l^i_2, \ldots, l^i_{M^i-1}\}$, the log-likelihood ratio of the additional information is $Z^i$ and $Z^i=\{z^i_0, z^i_1, z^i_2, \ldots, z^i_{N'-1}\}$, i=0, 1, 2, ..., m-1, N' represents a quantity of element values of $Z^i$, and $M^i$ represents a quantity of element values of the any group of log-likelihood ratios;

the log-likelihood ratio of the additional information is generated by using the following method:

$$\text{for}(j=N^i;\ j<M^i;\ j=j+1)$$

$$z^i_{mod(j-N^i+\Delta^i,N')} = z^i_{mod(j-N^i+\Delta^i,N')} + F(l^i_j, l^i_{mod(j,N^i)}),$$

wherein
mod represents a modulo operation, F represents a log-likelihood ratio decoupling operation function, and $\Delta^i$ represents a coupling sequence number offset value of the additional information.

**28.** The apparatus according to claim 26 or 27, wherein

$$\Delta^i = i * mod\left(\sum_{i=0}^{m-1}(E^i - N^i), N'\right),$$

wherein
$\Sigma$ represents a summation operation.

**29.** The apparatus according to claim 24, wherein the sum value of the log-likelihood ratios that are of the additional information and that respectively correspond to the m groups of log-likelihood ratios is Z and $Z = \sum_{i=0}^{m-1} Z^i$, wherein
$Z^i$ represents a log-likelihood ratio that is of the additional information and that corresponds to an $i^{th}$ group of log-likelihood ratios in the m groups of log-likelihood ratios.

**30.** The apparatus according to any one of claims 22 to 29, wherein the first codeword is a polar code.

**31.** A communication apparatus, comprising a processor coupled to a memory, wherein the processor is configured to invoke a program stored in the memory, to perform the method according to any one of claims 1 to 6, or perform the method according to any one of claims 7 to 15.

**32.** A communication apparatus, comprising a processor and a memory, wherein the memory is configured to store computer instructions, and when the communication apparatus runs, the processor executes the computer instructions stored in the memory, to perform the method according to any one of claims 1 to 6, or perform the method according to any one of claims 7 to 15.

**33.** A communication apparatus, comprising a processor and an interface circuit, wherein the processor is configured to: communicate with another apparatus through the interface circuit, and perform the method according to any one of claims 1 to 6, or perform the method according to any one of claims 7 to 15.

**34.** A computer program product, wherein the computer program product comprises a computer program or instructions; and when the computer program or the instructions are run on a processor, the processor is enabled to perform the method according to any one of claims 1 to 6, or the method according to any one of claims 7 to 15.

**35.** A computer-readable storage medium, wherein the storage medium stores a computer program or instructions; and when the computer program or the instructions are executed by a communication apparatus, the method according to any one of claims 1 to 6 is implemented, or the method according to any one of claims 7 to 15 is implemented.

**36.** A communication system, comprising a first apparatus configured to perform the method according to any one of claims 1 to 6, and a second apparatus configured to perform the method according to any one of claims 7 to 15.

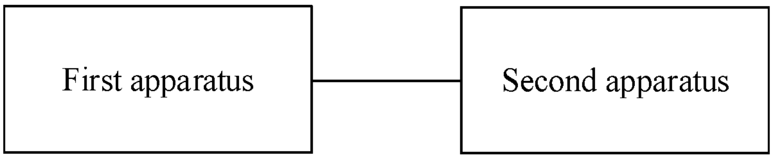


FIG. 1

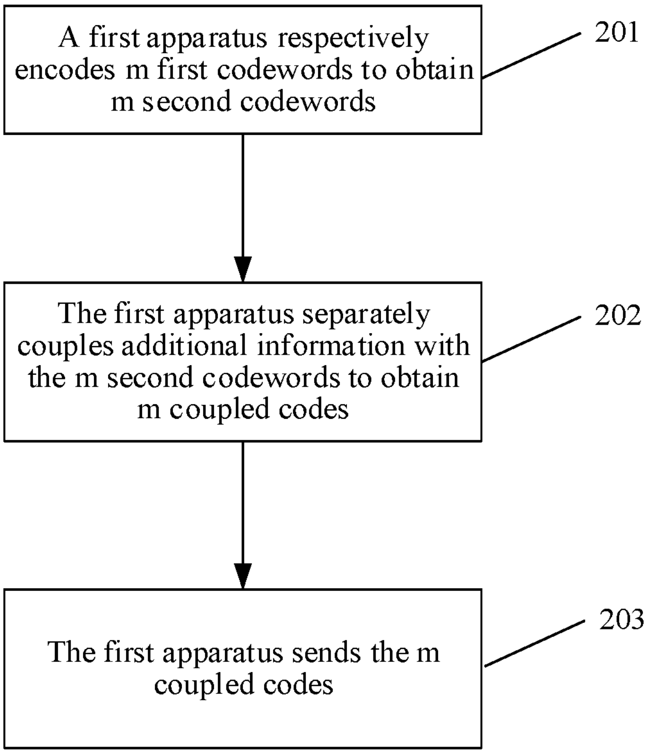


FIG. 2

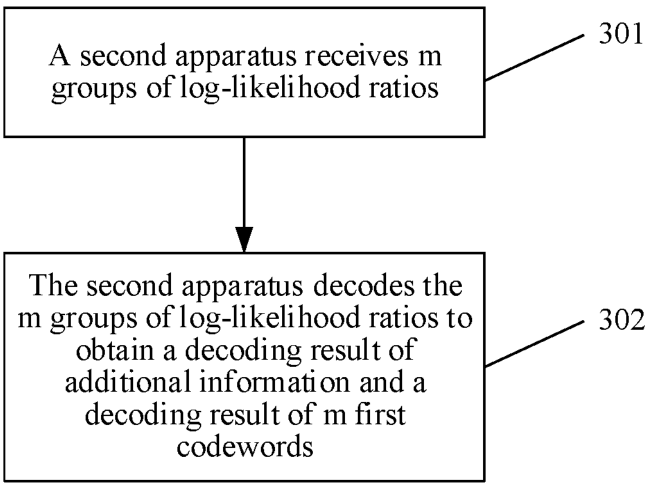


FIG. 3

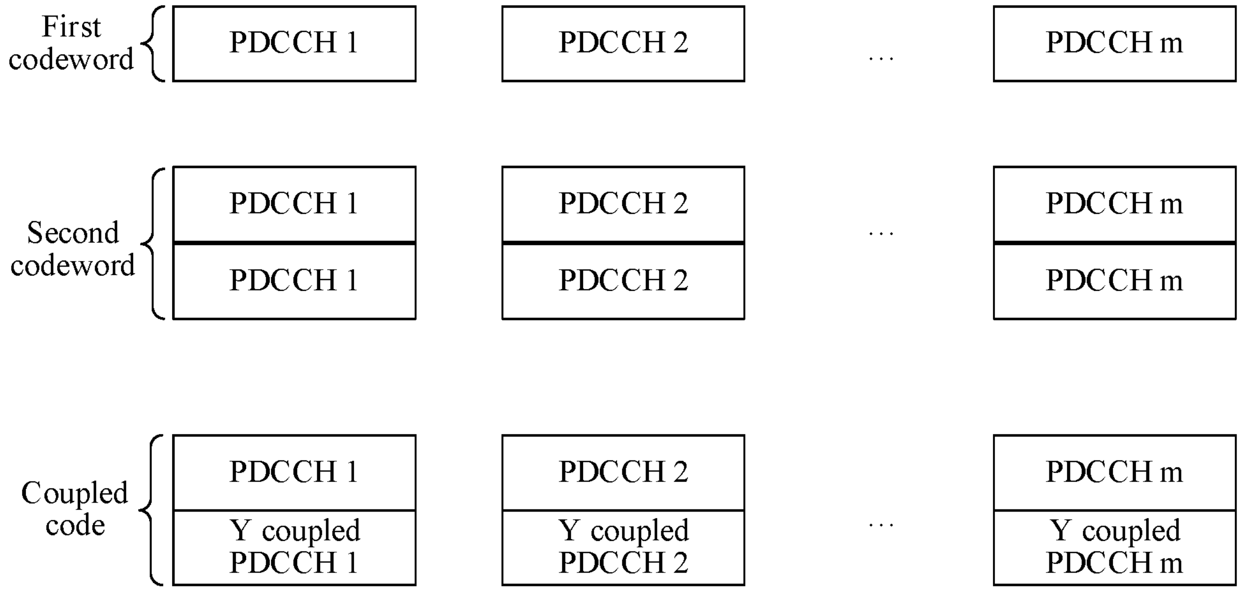


FIG. 4

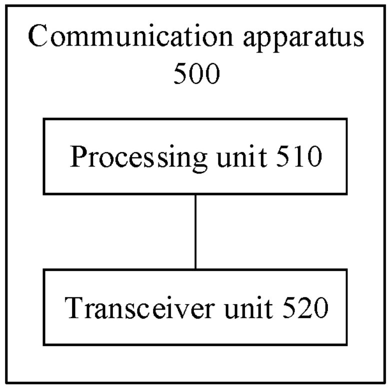


FIG. 5

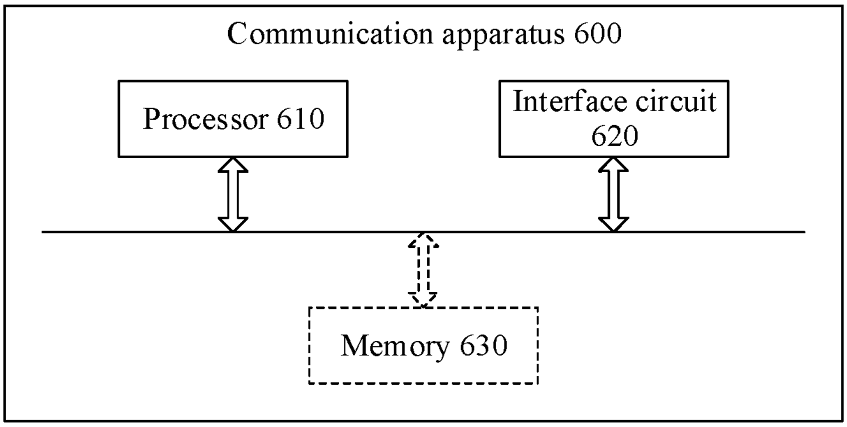


FIG. 6

**INTERNATIONAL SEARCH REPORT**

International application No.
**PCT/CN2022/130828**

**A. CLASSIFICATION OF SUBJECT MATTER**

H04L27/00(2006.01)i

According to International Patent Classification (IPC) or to both national classification and IPC

**B. FIELDS SEARCHED**

Minimum documentation searched (classification system followed by classification symbols)

IPC: H04L

Documentation searched other than minimum documentation to the extent that such documents are included in the fields searched

Electronic data base consulted during the international search (name of data base and, where practicable, search terms used)

3GPP, CJFD, CNTXT, DWPI, ENTXT, ENTXTC, VEN, WPABS, WPABSC: 编码, 重复, 解码, 耦合, 对应, polar, repetitive, correspond+, encod+, decod+

**C. DOCUMENTS CONSIDERED TO BE RELEVANT**

| Category* | Citation of document, with indication, where appropriate, of the relevant passages | Relevant to claim No. |
|---|---|---|
| A | US 2010111145 A1 (BROADCOM CORP.) 06 May 2010 (2010-05-06)<br>description, paragraphs [0024]-[0059] | 1-36 |
| A | US 2017359085 A1 (FUJITSU LIMITED; MOBILE TECHNO CORP.) 14 December 2017 (2017-12-14)<br>entire document | 1-36 |
| A | CN 109391356 A (HUAWEI TECHNOLOGIES CO., LTD.) 26 February 2019 (2019-02-26)<br>entire document | 1-36 |

☐ Further documents are listed in the continuation of Box C. ☑ See patent family annex.

* Special categories of cited documents:
- "A" document defining the general state of the art which is not considered to be of particular relevance
- "D" document cited by the applicant in the international application
- "E" earlier application or patent but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| Date of the actual completion of the international search | Date of mailing of the international search report |
|---|---|
| **30 June 2023** | **05 July 2023** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | Telephone No. |

Form PCT/ISA/210 (second sheet) (July 2022)

**INTERNATIONAL SEARCH REPORT**
**Information on patent family members**

International application No.
**PCT/CN2022/130828**

| Patent document cited in search report | Publication date (day/month/year) | Patent family member(s) | Publication date (day/month/year) |
|---|---|---|---|
| US 2010111145 A1 | 06 May 2010 | None | |
| US 2017359085 A1 | 14 December 2017 | JP 2017224874 A | 21 December 2017 |
| CN 109391356 A | 26 February 2019 | None | |

Form PCT/ISA/210 (patent family annex) (July 2022)